(19) Europäisches Patentamt
European Patent Office
Office européen des brevets

(11) **EP 2 763 304 B1**

(12) **EUROPEAN PATENT SPECIFICATION**

(45) Date of publication and mention
of the grant of the patent:
**09.11.2016  Bulletin 2016/45**

(51) Int Cl.:
***H02M 7/48*** *(2007.01)*

(21) Application number: **11873210.6**

(22) Date of filing: **30.09.2011**

(86) International application number:
**PCT/JP2011/072641**

(87) International publication number:
**WO 2013/046458 (04.04.2013 Gazette 2013/14)**

(54) **POWER CONVERSION DEVICE**

STROMWANDLER

DISPOSITIF DE TRANSFORMATION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.08.2014  Bulletin 2014/32**

(73) Proprietor: **Mitsubishi Electric Corporation
Tokyo 100-8310 (JP)**

(72) Inventors:
• **YOKOZUTSUMI, Ryo**
**Tokyo 100-8310 (JP)**
• **MURAHASHI, Akihiro**
**Tokyo 100-8310 (JP)**
• **JIMICHI, Takushi**
**Tokyo 100-8310 (JP)**
• **AZUMA, Satoshi**
**Tokyo 100-8310 (JP)**
• **SHIRAKI, Yasuhiro**
**Tokyo 100-8310 (JP)**

(74) Representative: **Zech, Stefan Markus et al
Meissner Bolte Patentanwälte
Rechtsanwälte Partnerschaft mbB
Widenmayerstraße 47
80538 München (DE)**

(56) References cited:
**EP-A2- 1 724 911      JP-A- 2000 031 325
JP-A- 2000 245 155      JP-A- 2008 301 555
JP-A- 2008 301 555      JP-A- 2011 036 020**

**Description**

Field

The present invention relates to a power conversion device.

Background

A technique has been known, in which a power conversion device includes an inverter that receives power from a direct-current power supply system and drives a motor as a load, a fin as a cooling unit that cools down the inverter, a first core including a through hole that allows passage of a high voltage line that connects the direct-current power supply system and the inverter and a ground line that grounds the inverter, a first ground line that grounds the fin, a second ground line that grounds the motor, and a second core including a through hole. In this power conversion device, the first ground line is connected to a ground line on the side of the direct-current power supply system with respect to the first core, and a resonance path that circulates the inverter, the fin, the first ground line, a common ground point of the first ground line and the second ground line, the motor, the second ground line, and the inverter is arranged to pass through the through hole of the second core, thereby increasing high frequency impedance of the resonance path and suppressing a noise source current in the power conversion device (see, for example, Patent Literature 1). A further example for a motor system which can suppress adverse influences of electromagnetic noise by providing a noise return line between the motor and the inverter is described in Patent Literature 2.

Citation List

Patent Literature

   Patent Literature 1: Japanese Patent Application Laid-open No. 2008-301555
   Patent Literature 2: EP 1 724 911 A2

Summary

Technical Problem

According to the technique described in Patent Literature 1 mentioned above, the effects of suppressing a high frequency current, a resonance current, and the like, as well as the noise source current are obtained. However, in a state where a switching frequency is shifted to a high frequency side with respect to a switching element included in the power conversion device, the noise source current, the high frequency current, and the resonance current need to be further decreased.

The present invention has been achieved in view of the above, and an object of the present invention is to provide a power conversion device that can further reduce a noise source current, a high frequency current, and a resonance current.

Solution to Problem

The present invention is directed to a power conversion device that achieves the object. The power conversion device includes an inverter that is arranged in a casing and is adapted to receive power from a direct-current power supply system, and drive a motor that is connected to a first ground; a cooler that is adapted to cool down the inverter; a first core including a through hole that allows passage of a positive side conductor that connects the direct-current power supply system and the inverter and a negative side conductor that connects the inverter to a second ground; a first ground conductor that connects the negative side conductor on a side of the direct-current power supply system with respect to the first core and the cooler; and a second ground conductor connects the negative side conductor on the side of the direct-current power supply system with respect to the first core and the motor via a capacitive element; wherein the cooler is grounded to the second ground via the first ground conductor, the casing is grounded to a third ground, and the cooler is also connected to the casing.

Advantageous Effects of Invention

According to the present invention, a noise source current, a high frequency current, and a resonance current can further be reduced.

Brief Description of Drawings

FIG. 1 is a configuration example of an electric-vehicle driving system including a power conversion device according to an embodiment of the present invention.
FIG. 2 is exemplary diagrams of a first noise path that can be generated in the power conversion device according to the present embodiment.
FIG. 3 is exemplary diagrams of a second noise path that can be generated in the power conversion device according to the present embodiment.
FIG. 4 is exemplary diagrams of a third noise path that can be generated in the power conversion device according to the present embodiment.
FIG. 5 is exemplary diagrams of a fourth noise path that can be generated in the power conversion device according to the present embodiment.
FIG. 6 is a perspective view of a general shape of a ring-shaped ferrite core as an example of a first core and a second core according to the present embodiment.
FIG. 7 is an example of impedance characteristics that are suitable for the first core and the second core according to the present embodiment.

Description of Embodiments

Exemplary embodiments of a power conversion device according to the present invention will be explained below in detail with reference to the accompanying drawings. The present invention is not limited to the embodiments.

<Embodiments>

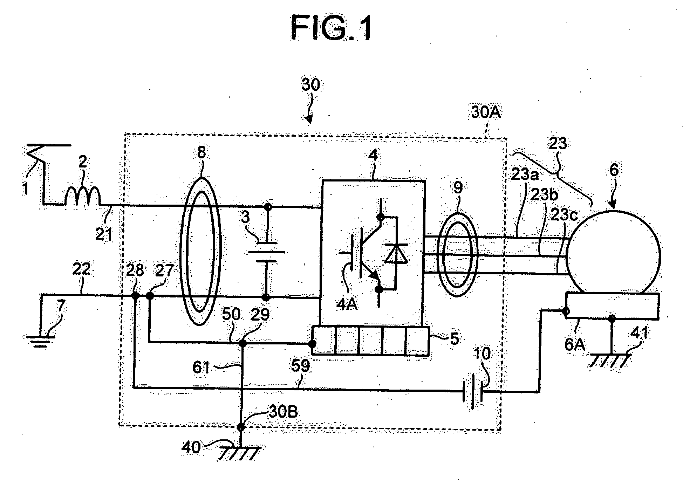

FIG. 1 is a configuration example of an electric-vehicle driving system including a power conversion device according to an embodiment of the present invention. The electric-vehicle driving system according to the present embodiment includes, as shown in FIG. 1, a pantograph 1, a reactor 2, a power conversion unit 30, and a motor 6. The power conversion unit 30 includes a filter condenser 3 that receives power from a direct-current power supply system via the pantograph 1 and the reactor 2 and accumulates direct-current power, an inverter 4 that converts a direct-current voltage of the filter condenser 3 into an alternate-current voltage and drives the motor 6 as a load, a first core 8 provided on an input side of the inverter 4 as an element of impedance, a second core 9 provided on an output side of the inverter 4 as an element of impedance, a fin 5 as a cooler that cools down a semiconductor element 4A constituting the inverter 4, and a condenser 10 as a capacitive element for connecting ground potential on the input side of the inverter 4 and ground potential of the motor 6 in an alternating-current manner.
A connection configuration of the power conversion unit 30 and external constituent elements and an internal connection configuration of the power conversion unit 30 are described below.
First, two lines including a positive side conductor 21 that connects the reactor 2 and the inverter 4 and a negative side conductor 22 that grounds the inverter 4 to a ground 7 are provided on an input side of the power conversion unit 30 (the side of the direct-current power supply system). The positive side conductor 21 and the negative side conductor 22 are arranged to pass through a through hole of the first core 8 and connected to the inverter 4.
Meanwhile, load conductors 23 (23a, 23b, and 23c), which connect the inverter 4 and the motor 6 as a load, are provided on an output side of the power conversion unit 30 (the side of the motor 6). These load conductors 23 are arranged to pass through a through hole of the second core 9 and connected to the motor 6. A ground 41 for grounding the motor 6 as a device is provided in a peripheral portion of the motor 6, and a motor yoke 6A, which is a part of a configuration that constitutes the motor 6, and the ground 41 are electrically connected to each other.
Regarding the inside of the power conversion unit 30, a ground conductor 50, which is a first ground conductor (a conductor such as a ground line or a bus bar), is connected to the fin 5 and a connection point 27 that is an arbitrary point on the negative side conductor 22 located on the side of the direct-current power supply system with respect to the first core 8. That is, the fin 5 is grounded to the same potential (equipotential) as the ground 7 via the ground conductor 50 and the negative side conductor 22. A ground conductor 59, which is a second ground conductor, connects the motor yoke 6A, which is grounded to the ground 41, to a connection point 28 on the negative side conductor 22 located on the side of the direct-current power supply system with respect to the first core 8 via the condenser 10. A ground conductor 61, which is a third ground conductor, is connected between a connection point 29, which is an arbitrary point on the ground conductor 50, and a ground 40 via a connection point 30B that is an arbitrary point on a casing 30A of the power conversion unit 30. The connection points 27 and 28 can be connected to any portion (even outside the casing 30A) so long as the points are on the side of the direct-current power supply system with respect to the core 8 in the power conversion unit 30.

Although an example in which the ground conductor 61 is connected to the connection point 29 that is an arbitrary point on the ground conductor 50 is shown in FIG. 1, the ground conductor 61 can be connected to an end portion of one side of the ground conductor 50 or the fin 5 located near the end portion of the one side of the ground conductor 50, or can be connected to the connection point 27 that is an end portion of the other side of the ground conductor 50 or in proximity of the end portion of the other side of the ground conductor 50. That is, the arbitrary point on the negative side conductor 22, which is located on the side of the direct-current power supply system with respect to the fin 5 or the first core 8, is grounded to the same potential (equipotential) as the ground 40 via the ground conductor 61.

The fin 5 can be directly connected to the casing 30A of the power conversion unit 30. This configuration eliminates the necessity of insulating the fin 5 from the casing of the power conversion unit 30, thereby enabling a simplification of the manufacturing process.

Although an example in which the ground conductor 61 is connected to the arbitrary connection point 30B on the casing 30A, and the connection point 30B is connected to the ground 40 is shown in FIG. 1, it is not necessary that the ground point on the casing 30A is the connection point 30B, and the casing 30A can be grounded at any point other than the connection point 30B. In this case, by connecting the ground conductor 61 to the casing 30A, an electrical grounding is obtained.

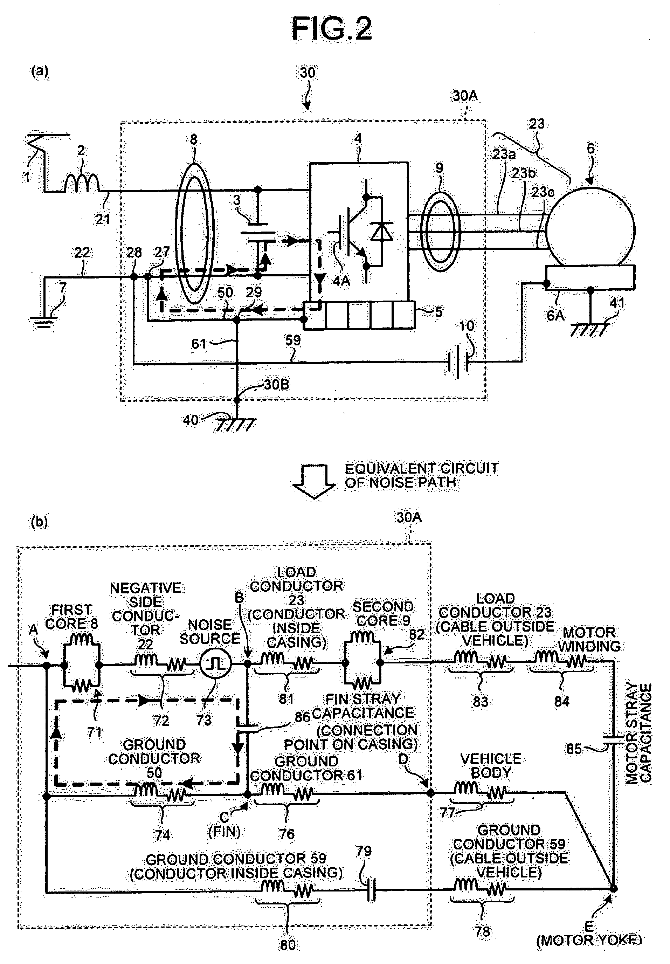

An effect of reducing the noise current, which is unique to the power conversion device according to the present embodiment configured as shown in FIG. 1, is described below with reference to FIG. 2 to FIG. 5.

FIG. 2 is exemplary diagrams of a first noise path that can be generated in the power conversion device according to the present embodiment. More specifically, FIG. 2(a) depicts the first noise path on the configuration diagram shown in FIG. 1, and FIG. 2(b) depicts an equivalent circuit of the noise path in an electric-vehicle driving system.

The equivalent circuit shown in FIG. 2(b) is described first. In FIG. 2(b), a point A indicates the connection point 28 (or the connection point 27), a point B indicates an output terminal of the inverter 4, a point C indicates the fin 5 (or the connection point 29), a point D indicates the connection point 30B on the casing 30A, and a point E indicates the motor yoke 6A. A circuit unit 71 that simulates the impedance of the first core 8, a circuit unit 72 that simulates the impedance of the negative side conductor 22 located on the right side of the connection point 28 (the side of the inverter 4), and a noise source 73 as a source of generating a common mode noise are arranged between the point A and the point B. Similarly, a fin stray capacitance 86 that is a stray capacitance of the fin 5 is arranged between the point B and the point C, a circuit unit 74 that simulates the impedance of the ground conductor 50 is arranged between the point A and the point C, a circuit unit 76 that simulates the impedance of the ground conductor 61 is arranged between the point C and the point D, a circuit unit 77 that simulates the impedance of a vehicle body is arranged between the point D and the point E, a circuit unit 80 that simulates the impedance of a line of the ground conductor 59 inside the casing, a capacitance 79 that is a capacitance value of the condenser 10, and a circuit unit 78 that simulates the impedance of a cable of the ground conductor 59 outside the vehicle are arranged between the point A and the point E, and a circuit unit 81 that simulates the impedance of a conductor of the load conductors 23 inside the casing, a circuit unit 82 that simulates the impedance of the second core 9, a circuit unit 83 that simulates the impedance of a cable of the load conductors 23 outside the vehicle, a circuit unit 84 that simulates the impedance of a motor winding of the motor 6, and a motor stray capacitance 85 that is the stray capacitance of the motor 6 are arranged between the point B and the point E.

As described above, the equivalent circuit of the electric-vehicle driving system can be represented as the equivalent circuit shown in FIG. 2(b), and a plurality of noise paths can be generated in the electric-vehicle driving system. FIGS. 2(a) and 2(b) depict the first noise path among the plurality of noise paths that can be generated in plural numbers. As indicated by the thick dashed line in FIG. 2(a), the first noise path is a path of the inverter 4 → the fin 5 → the first core 8 → the inverter 4, with the inverter 4 as the start point and the end point. In this first noise path, as shown in FIG. 2(b), a resistance component, an inductance component, and a capacitance component are included in the path, which constitutes a resonance circuit. Thus the impedance is likely to be decreased at a specific frequency so that a noise current is likely to be increased. On the other hand, in this first noise path, the first core 8 has an impedance larger than impedances of the other impedance elements in the path, and thus a resonance frequency can be decreased so that it is possible to suppress decrease of the impedance in a high frequency band. As a result, a switching frequency is shifted to a high frequency side with respect to a switching element included in the power conversion device, and even under a condition that the noise source current, the high frequency current, and the resonance current are increased in a higher frequency region, the increase of these currents can be suppressed.

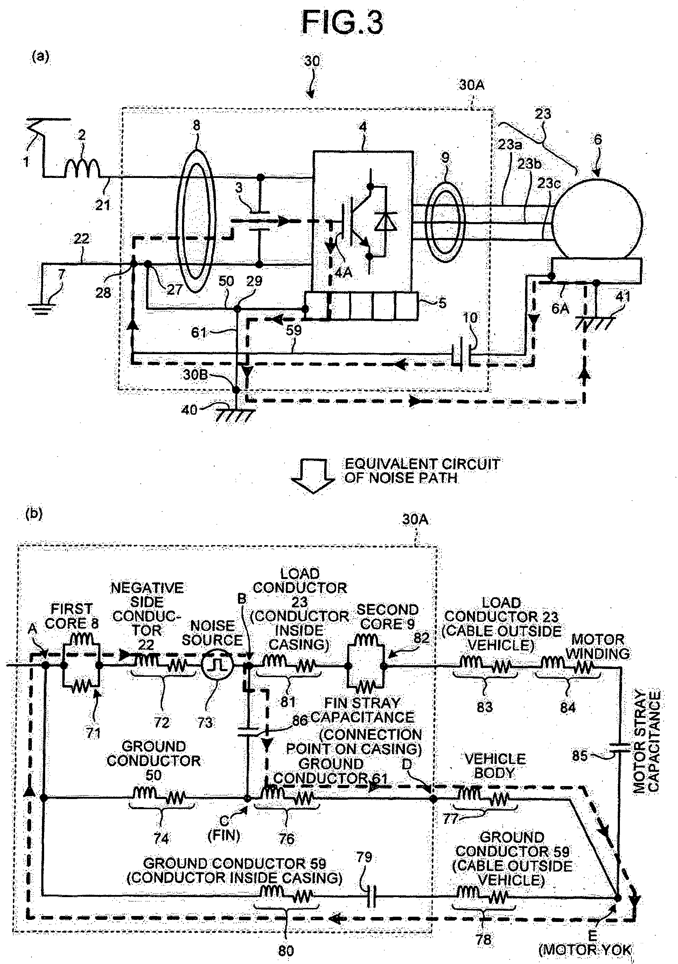

FIG. 3 is exemplary diagrams of a second noise path that can be generated in the power conversion device according to the present embodiment, and in the same manner as FIG. 2, the path is shown on the configuration diagram and the equivalent circuit diagram.

As indicated by the thick dashed line in FIG. 3(a), the second noise path is a path of the inverter 4 → the fin 5 → the ground 40 → the ground 41 → the motor yoke 6A → the condenser 10 → the first core 8 → the inverter 4, with the inverter 4 as the start point and the end point. In this second noise path also, as shown in FIG. 3(b), a resistance component, an inductance component, and a capacitance component are included in the path, which constitute a resonance circuit, and thus the impedance is likely to be decreased at a specific frequency so that a noise current is likely to be increased. However, in the second noise path also, the first core 8 has an impedance larger than impedances of the other impedance elements in the path, and thus a resonance frequency can be decreased so that it is possible to suppress decrease of the impedance in a high frequency band. As a result, a switching frequency is shifted to a high frequency side with respect to a switching element included in the power conversion device, and even under a condition that the noise source current, the high frequency current, and the resonance current are increased in a higher frequency region, the increase of these currents can be suppressed. Although the second noise path shown in FIG. 3 is a new noise path caused by the connection of the ground conductor 61, the first core 8 exists in the second noise path as described above and the first noise path shown in FIG. 2 has a lower impedance, and thus there is practically no adverse effect due to the second noise path.

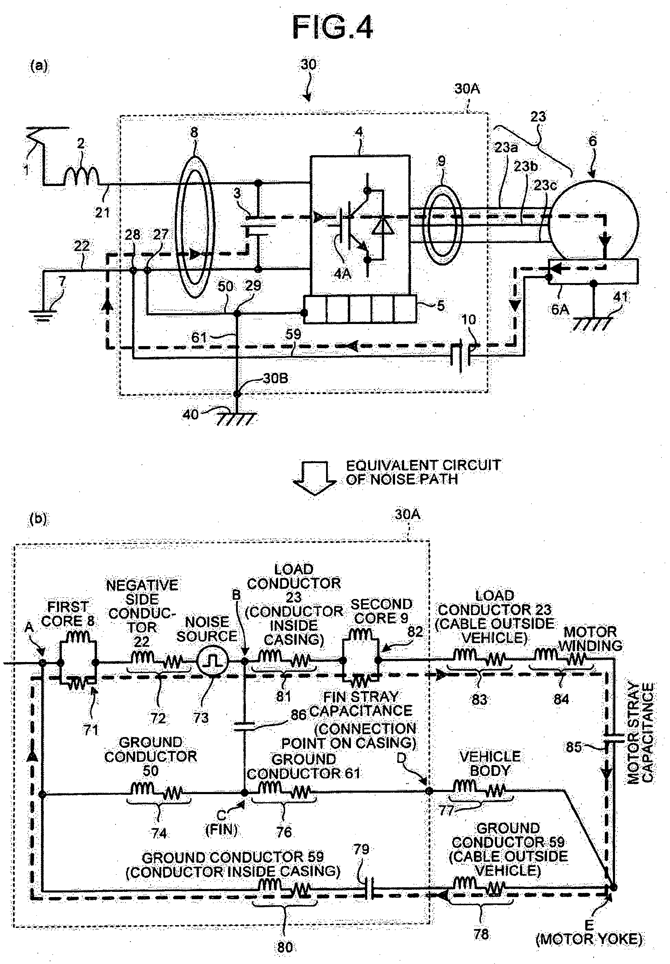

FIG. 4 is exemplary diagrams of a third noise path that can be generated in the power conversion device according to the present embodiment, and in the same manner as FIGS. 2 and 3, the path is shown on the configuration diagram and the equivalent circuit diagram.

As indicated by the thick dashed line in FIG. 4(a), the third noise path is a path of the inverter 4 → the second core 9 → the motor 6 → the motor yoke 6A → the condenser 10 → the first core 8 → the inverter 4, with the inverter 4 as the start point and the end point. In this third noise path also, as shown in FIG. 4(b), a resistance component, an inductance component, and a capacitance component are included in the path, which constitute a resonance circuit, and thus the impedance is likely to be decreased at a specific frequency so that a noise current is likely to be increased. However, in the third noise path, the first core 8 and the second core 9 have impedances larger than impedances of the other impedance elements in the path, and thus a resonance frequency can be decreased so that it is possible to suppress decrease of the impedance in a high frequency band. As a result, a switching frequency is shifted to a high frequency side with respect to a switching element included in the power conversion device, and even under a condition that the noise source current, the high frequency current, and the resonance current are increased in a higher frequency region, the increase of these currents can be suppressed. Furthermore, in the third noise path, the impedance of the second core 9 is added in series to the first core 8, and thus the effect of suppressing the decrease of the impedance in the high frequency band can be enhanced.

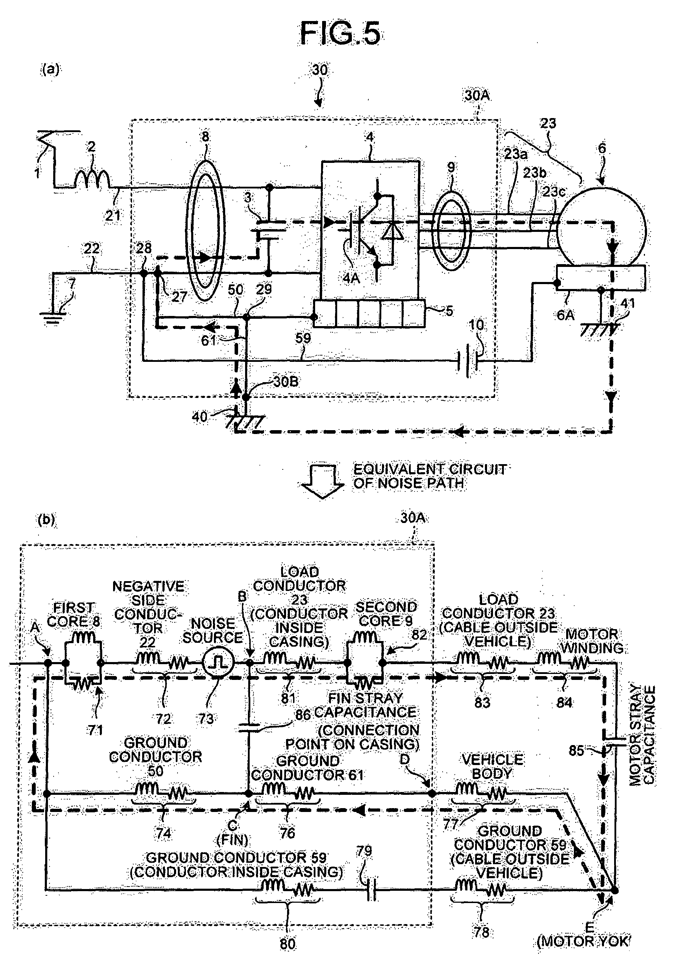

FIG. 5 is exemplary diagrams of a fourth noise path that can be generated in the power conversion device according to the present embodiment, and in the same manner as FIGS. 2 to 4, the path is shown on the configuration diagram and the equivalent circuit diagram.

As indicated by the thick dashed line in FIG. 5(a), the fourth noise path is a path of the inverter 4 → the second core 9 → the motor 6 → the motor yoke 6A → the ground 41 → the ground 40 → the first core 8 → the inverter 4, with the inverter 4 as the start point and the end point. In the fourth noise path also, as shown in FIG. 4(b), a resistance component, an inductance component, and a capacitance component are included in the path, which constitute a resonance circuit, and thus the impedance is likely to be decreased at a specific frequency so that a noise current is likely to be increased. However, in the fourth noise path also, similarly to the third noise path, both the first core 8 and the second core 9 have impedances larger than impedances of the other impedance elements in the path, and thus a resonance frequency can be decreased so that it is possible to suppress decrease of the impedance in a high frequency band. As a result, a switching frequency is shifted to a high frequency side with respect to a switching element included in the power conversion device, and even under a condition that the noise source current, the high frequency current, and the resonance current are increased in a higher frequency region, the increase of these currents can be suppressed. Furthermore, in the fourth noise path also, similarly to the third noise path, the impedance of the second core 9 is added in series to the first core 8, and thus the effect of suppressing the decrease of the impedance in the high frequency band can be enhanced.

The fourth noise path is a path generated by connecting the ground conductor 61 between the connection point 29 on the ground conductor 50 and the ground 40, which has a parallel relationship with the third noise path, and thus there is a concern that the impedance is decreased. However, as described above, in the third and fourth paths, the motor stray capacitance has a relatively large impedance in a low frequency band while both the first core 8 and the second core 9 are arranged on the path, and thus such a concern can be eliminated.

Furthermore, because the third noise path is relatively longer than the other noise paths, there is a concern that the amount of noise emitted in proportion to the area of a loop formed by the path is also relatively increased. However, the connection of the ground conductor 61 between the connection point 29 on the ground conductor 50 and the ground 40 enables the potential of the point C of the fin 5 to be more stabilized with respect to the point E of the motor yoke 6A, and thus the current flowing through the third noise path is reduced. Therefore, the noise amount emitted by the third noise path can be reduced accordingly, and as a result, the concern is eliminated. In addition, because it is not necessary to secure the insulation between the fin 5 and the casing 30A, unlike with the conventional case, simplification of the mechanical structure can also be achieved.

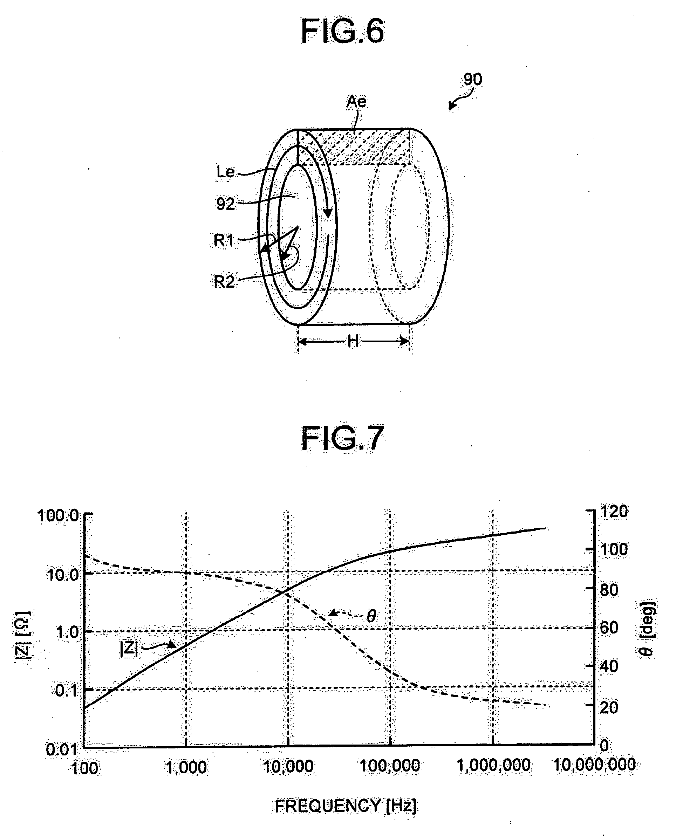

Impedances of the first core 8 and the second core 9 are described below. FIG. 6 is a perspective view of an overview shape of a ring-shaped ferrite core as an example of the first core 8 and the second core 9 according to the present embodiment. This ring-shaped ferrite core 90 includes a through hole 92 as shown in the drawing. When the ring-shaped ferrite core 90 is used as the first core 8, the positive side conductor 21 and the negative side conductor 22 are inserted through the through hole 92. Further, when the ring-shaped ferrite core 90 is used as the second core 9, the load conductors 23 (23a, 23b, and 23c) are inserted through the through hole 92.

It is known that the impedance of the ring-shaped ferrite core 90 satisfies relationships represented by the following Expressions (1) and (2).

$$|Z| \propto (Ae/Le) \qquad \cdots \cdots (1)$$

$$Ae/Le = (H/2\pi) \cdot LN(R1/R2) \qquad \cdots \cdots (2)$$

The meaning of the symbols included in Expressions (1) and (2) is as follows.

$|Z|$: absolute value of impedance, Ae: effective cross section area, Le: effective magnetic path length, H: thickness, R1: outer diameter, R2: inner diameter

As can be understood from Expressions (1) and (2), in order to increase the impedance of the ring-shaped ferrite core 90, it is effective to increase the ratio of the effective cross section area Ae and the effective magnetic path length Le (the ratio of the effective cross section area Ae to the effective magnetic path length Le). Specifically, it is sufficient to reduce the inner diameter R2, to increase the thickness H, and to increase the outer diameter R1.

As a switching element included in the inverter, a semiconductor transistor element of silicon (Si) (hereinafter, "Si element") is generally used.

On the other hand, in recent years, as a substitute for the Si element, semiconductor switching elements of silicon carbide (SiC) (hereinafter, "SiC element") have been drawing attention.

The reason why the SiC element can perform a high-speed switching operation is because it can be used at a high temperature, with its high heat resistance, so that the allowable operating temperature of a module including the SiC element can be raised higher, and thus, even when the switching speed is increased by increasing a carrier frequency, it is possible to suppress any increase in the size of the cooler.

However, the usage of the SiC element increases a high frequency component of an output voltage of the inverter, and thus a high frequency current generated by the high frequency voltage works as a noise source, resulting in a concern that malfunctioning of a signaler or the like may be caused. The reason why the usage of the SiC element increases the high frequency component of the output voltage includes the following two main points.

(1) Because the SiC is a wide-bandgap semiconductor, a structure of a unipolar device can be adopted, so that an accumulated carrier is substantially zero. Therefore, a loss at the time of switching can be reduced while dv/dt and di/dt are increased and noise is increased.

(2) Because the usage of the SiC element can reduce the loss per switching, a switching frequency can be increased for the purpose of improving controllability and reducing a motor loss. As a result, the frequency of the switching per second is increased, and thus the noise is increased accordingly.

As described above, when the SiC element is used as the switching element included in the inverter, the high frequency current generated by the high frequency component of the output voltage of the inverter works as a noise source, resulting in a concern that malfunctioning of an on-vehicle signaler, a ground signaler, or the like may be caused.

Impedance characteristics of the first core 8 and the second core 9, which can be suitably used even when the SiC element mentioned above is used, are described. FIG. 7 is an example of the impedance characteristics that are suitable for the first core 8 and the second core 9 according to the present embodiment. In FIG. 7, the waveform of the solid line portion indicates a frequency characteristic on a magnitude (an absolute value) of the impedance, and the waveform of the dashed line portion indicates a frequency characteristic on a phase of the impedance.

The roles of the first core 8 and the second core 9 are to increase the impedances of the first to fourth noise paths described above, thus reducing the noise currents on these paths. Regarding the impedance characteristics shown in FIG. 7, the absolute value of the impedance is increased as the frequency is increased, and the phase of the impedance approaches zero (deg) as the frequency is increased. That is, the characteristics shown in FIG. 7 represent, as the frequency is increased, characteristics that gradually change from an inductance component to a resistance component and the absolute value of the impedance is increased. As a main component of the impedance approaches a resistance, a damping effect can be obtained, and as the absolute value of the impedance is increased, the noise current can be decreased. Therefore, it can be said that the ferrite core having the characteristics as shown in FIG. 7 is an impedance element that is suitable when it is used as the first core 8 and the second core 9 according to the present embodiment.

When the ferrite core as shown in FIG. 6 is used as the first core 8 and the second core 9, as can be understood from the descriptions of FIG. 6, an increase of the impedance leads to an increase of the volume. On the other hand, in the case of the configuration according to the present embodiment, because the configuration includes the first core 8 and the second core 9 as shown in FIG. 1 or the like, when there is a weight restriction, a trade-off needs to be considered in the performance, the weight, or the volume between the first core 8 and the second core 9.

Considering operations of the first core 8 and the second core 9, only the third and fourth noise paths pass through the second core 9 while all the first to fourth noise paths described above pass through the first core 8. Therefore, from a viewpoint of reducing the overall noise current, it is more effective to increase the impedance of the first core 8 than the impedance of the second core 9. As in the above example, the impedance of the ferrite core is increased as the volume is increased. Therefore, when the same material is used, it is more effective to increase the weight or the volume of the first core 8 than the weight or the volume of the second core 9.

Although a configuration of using both the first core 8 and the second core 9 has been described in the present embodiment, because the currents flowing through the third and fourth noise paths described above are decreased depending on the magnitude of the stray capacitance of the motor, the second core 9 can be omitted in this case.

In the present embodiment, as the element for reducing the noise source current, the high frequency current, and the resonance current, for example, the ferrite core (a magnetic core) as shown in FIG. 6 is used; however, as substitute for the magnetic core, for example, an element such as a reactor and a common-mode choke coil, that is, an impedance element having an inductance component, can also be used. The point is that, so long as the resonance frequency at the time when the noise source current, the high frequency current, and the resonance current flow can be shifted to a frequency band that does not affect an on-vehicle signaler, a ground signaler, or the like, any type of impedance element can be used.

Industrial Applicability

As described above, the power conversion device according to the present invention is useful in further reducing a noise source current, a high frequency current, and a resonance current.

Reference Signs List

| | |
|---|---|
| 1 | pantograph |
| 2 | reactor |
| 3 | filter condenser |
| 4 | inverter |
| 4A | semiconductor element |
| 5 | fin |
| 6 | motor |
| 6A | motor yoke |
| 7, 40, 41 | ground |
| 8 | first core |
| 9 | second core |
| 10 | condenser |
| 21 | positive side conductor |
| 22 | negative side conductor |
| 23 | load conductor |
| 27, 28, 29, 30B | connection point |
| 30 | power conversion unit |
| 30A | casing |
| 50 | ground conductor (first ground conductor) |
| 59 | ground conductor (second ground conductor) |

| 61 | ground conductor (third ground conductor) |
|---|---|

**Claims**

1.  A power conversion device (30) comprising:

    an inverter (4) that is arranged in a casing (30A) and is adapted to receive power from a direct-current power supply system, and drive a motor (6) that is connected to a first ground (41);
    a cooler (5) that is adapted to cool down the inverter (4);
    a first core (8) including a through hole that allows passage of a positive side conductor (21) that connects the direct-current power supply system and the inverter (4) and a negative side conductor (22) that connects the inverter (4) to a second ground (7);
    a first ground conductor (50) that connects the negative side conductor (22) on a side of the direct-current power supply system with respect to the first core (8) and the cooler (5); and
    a second ground conductor (59) that connects the negative side conductor on the side of the direct-current power supply system with respect to the first core (8) and the motor (6) via a capacitive element (10),
    **characterized in that**
    the cooler (5) is grounded to the second ground (7) via the first ground conductor (50), the casing (30A) is grounded to a third ground (40), and the cooler (5) is also connected to the casing (30A).

2.  The power conversion device (30) of claim 1, wherein
    the second ground conductor (59) is adapted to ground the motor (6) in an alternate-current manner via the capacitive element (10), the power conversion device (30) further comprising:

    a third ground conductor (61) including one end that is connected to the negative side conductor (22) on the side of the direct-current power supply system or the first ground conductor (50) with respect to the first core (8) and the other end that is connected to the third ground (40).

3.  The power conversion device (30) of claims 1or 2, wherein the first ground (41) and the third ground (40) are connected to each other via a vehicle body.

4.  The power conversion device (30) according to claim 2, wherein the first core (8) is arranged such that, when the inverter (4) works as a noise source, a current path through which a current flows in and out the inverter (4) through the cooler (5), the first ground conductor (50), and the negative side conductor (22) passes through the first core (8).

5.  The power conversion device (30) according to claim 2, wherein the first core (8) is arranged such that, when the inverter (4) works as a noise source, a current path through which a current flows in and out the inverter (4) through the cooler (5), the third ground conductor (61), the motor (6), the capacitive element (10), the second ground conductor (59), and the negative side conductor (22) passes through the first core (8).

6.  The power conversion device (30) according to claim 2, further comprising a second core (9) including a through hole that allows passage of a load conductor (23) that connects the inverter (4) and the motor (6).

7.  The power conversion device (30) according to claim 6, wherein the first core (8) and the second core (9) are arranged such that, when the inverter (4) works as a noise source, a current path through which a current flows in and out the inverter (4) through the load conductor (23), the motor (6), the capacitive element (10), the second ground conductor (59), and the negative side conductor (22) passes through the first core (8) and the second core (9).

8.  The power conversion device (30) according to claim 6, wherein the first core (8) and the second core (9) are arranged such that, when the inverter (4) works as a noise source, a current path through which a current flows in and out the inverter (4) through the load conductor (23), the motor (6), the third ground conductor (61), and the negative side conductor (22) passes through the first core (8) and the second core (9).

9.  The power conversion device (30) according to any one of claims 6 to 8, wherein an impedance of the first core (8) is larger than an impedance of the second core (9).

10. The power conversion device (30) according to any of claims 6 to 9,

wherein when a frequency of the noise source is increased above 10 kHz a phase of the impedance of each of the first core (8) and second core (9) gradually decreases from a value equal to or smaller than 80° to 0°.

11. The power conversion device (30) according to any one of claims 2, 4 to 8, wherein the casing (30A) that accommodates the inverter (4) is connected to the third ground (40); and
the third ground conductor (61) is connected to the casing (30A) that is connected to the third ground (40).

12. The power conversion device (30) according to any one of claims 1 to 11, wherein a switching device included in the inverter (4) is formed of a wide-bandgap semiconductor.


**Patentansprüche**

1. Leistungsumwandlungsvorrichtung (30), Folgendes aufweisend:

   einen Wechselrichter (4), der in einem Gehäuse (30A) angeordnet und dazu angepasst ist, Energie aus einem Gleichstromenergieversorgungssystem aufzunehmen und einen Motor (6) anzutreiben, der an eine erste Masse (41) angeschlossen ist;
   einen Kühler (5), der dazu angepasst ist, den Wechselrichter (4) abzukühlen;
   einen ersten Kern (8) mit einer Durchgangsöffnung, die den Durchtritt eines positivseitigen Leiters (21), der das Gleichstromenergieversorgungssystem und den Wechselrichter (4) verbindet, und eines negativseitigen Leiters (22) zulässt, der den Wechselrichter (4) an eine zweite Masse (7) anschließt;
   einen ersten Masseleiter (50), der den negativseitigen Leiter (22) auf einer Seite des Gleichstromenergieversorgungssystems in Bezug auf den ersten Kern (8) und den Kühler (5) anschließt; und
   einen zweiten Masseleiter (59), der den negativseitigen Leiter auf einer Seite des Gleichstromenergieversorgungssystems in Bezug auf den ersten Kern (8) und den Motor (6) über ein kapazitives Element (10) anschließt,
   **dadurch gekennzeichnet, dass**
   der Kühler (5) über den ersten Masseleiter (50) an die zweite Masse (7) gelegt ist, das Gehäuse (30A) an eine dritte Masse (40) gelegt ist, und der Kühler (5) auch an das Gehäuse (30A) angeschlossen ist.

2. Leistungsumwandlungsvorrichtung (30) nach Anspruch 1, wobei
der zweite Masseleiter (59) dazu angepasst ist, den Motor (6) auf eine Wechselstromweise über das kapazitive Element (10) an Masse zu legen, wobei die Leistungsumwandlungsvorrichtung (30) darüber hinaus umfasst:

   einen dritten Masseleiter (61) mit einem Ende, das an den negativseitigen Leiter (22) auf der Seite des Gleichstromenergieversorgungssystems oder den ersten Masseleiter (50) in Bezug auf den ersten Kern (8) und das andere Ende angeschlossen ist, das an die dritte Masse (40) angeschlossen ist.

3. Leistungsumwandlungsvorrichtung (30) nach Anspruch 1 oder 2, wobei die erste Masse (41) und die dritte Masse (40) über eine Fahrzeugkarosserie aneinander angeschlossen sind.

4. Leistungsumwandlungsvorrichtung (30) nach Anspruch 2, wobei der erste Kern (8) so angeordnet ist, dass, wenn der Wechselrichter (4) als Rauschquelle wirkt, ein Strompfad, durch den ein Strom in den und aus dem Wechselrichter (4) durch den Kühler (5), den ersten Masseleiter (50) und den negativseitigen Leiter (22) fließt, durch den ersten Kern (8) verläuft.

5. Leistungsumwandlungsvorrichtung (30) nach Anspruch 2, wobei der erste Kern (8) so angeordnet ist, dass, wenn der Wechselrichter (4) als Rauschquelle wirkt, ein Strompfad, durch den ein Strom in den und aus dem Wechselrichter (4) durch den Kühler (5), den dritten Masseleiter (61), den Motor (6), das kapazitive Element (10), den zweiten Masseleiter (59) und den negativseitigen Leiter (22) fließt, durch den ersten Kern (8) verläuft.

6. Leistungsumwandlungsvorrichtung (30) nach Anspruch 2, darüber hinaus einen zweiten Kern (9) mit einer Durchgangsöffnung umfassend, die den Durchtritt eines Lastleiters (23) zulässt, der den Wechselrichter (4) und den Motor (6) verbindet.

7. Leistungsumwandlungsvorrichtung (30) nach Anspruch 6, wobei der erste Kern (8) und der zweite Kern (9) so angeordnet sind, dass, wenn der Wechselrichter (4) als Rauschquelle wirkt, ein Strompfad, durch den ein Strom in den und aus dem Wechselrichter (4) durch den Lastleiter (23), den Motor (6), das kapazitive Element (10), den zweiten Masseleiter (59) und den negativseitigen Leiter (22) fließt, durch den ersten Kern (8) und den zweiten Kern (9) verläuft.

**8.** Leistungsumwandlungsvorrichtung (30) nach Anspruch 6, wobei der erste Kern (8) und der zweite Kern (9) so angeordnet sind, dass, wenn der Wechselrichter (4) als Rauschquelle wirkt, ein Strompfad, durch den ein Strom in den und aus dem Wechselrichter (4) durch den Lastleiter (23), den Motor (6), den dritten Masseleiter (61) und den negativseitigen Leiter (22) fließt, durch den ersten Kern (8) und den zweiten Kern (9) verläuft.

**9.** Leistungsumwandlungsvorrichtung (30) nach einem der Ansprüche 6 bis 8, wobei eine Impedanz des ersten Kerns (8) größer ist als eine Impedanz des zweiten Kerns (9).

**10.** Leistungsumwandlungsvorrichtung (30) nach einem der Ansprüche 6 bis 9, wobei, wenn eine Frequenz der Schallquelle über 10 kHz ansteigt, eine Phase der Impedanz jeweils des ersten Kerns (8) und zweiten Kerns (9) allmählich von einem Wert von gleich oder kleiner als 80° auf 0° sinkt.

**11.** Leistungsumwandlungsvorrichtung (30) nach einem der Ansprüche 2, 4 bis 8, wobei das Gehäuse (30A), das den Wechselrichter (4) aufnimmt, an die dritte Masse (40) angeschlossen ist; und
der dritte Masseleiter (61) an das Gehäuse (30A) angeschlossen ist, das an die dritte Masse (40) angeschlossen ist.

**12.** Leistungsumwandlungsvorrichtung (30) nach einem der Ansprüche 1 bis 11, wobei eine im Wechselrichter (4) enthaltene Schaltvorrichtung aus einem Halbleiter mit großer Bandlücke besteht.

## Revendications

**1.** Dispositif de conversion de puissance (30) comprenant :

un inverseur (4) qui est agencé dans un boîtier (30A) et est apte à recevoir de la puissance depuis un système d'alimentation en puissance en courant continu, et entraîner un moteur (6) qui est connecté à une première terre (41) ;
un refroidisseur (5) qui est apte à refroidir l'inverseur (4) ;
un premier noyau (8) incluant un trou traversant qui permet le passage d'un conducteur côté positif (21) qui connecte le système d'alimentation en puissance en courant continu et l'inverseur (4) et un conducteur côté négatif (22) qui connecte l'inverseur (4) à une deuxième terre (7) ;
un premier conducteur de terre (50) qui connecte le conducteur côté négatif (22) d'un côté du système d'alimentation en puissance en courant continu par rapport au premier noyau (8) et au refroidisseur (5) ; et
un deuxième conducteur de terre (59) qui connecte le conducteur côté négatif du côté du système d'alimentation en puissance en courant continu par rapport au premier noyau (8) et au moteur (6) via un élément capacitif (10),
**caractérisé en ce que**
le refroidisseur (5) est mis à la terre sur la deuxième terre (7) via le premier conducteur de terre (50), le boîtier (30A) est mis à la terre sur une troisième terre (40), et le refroidisseur (5) est également connecté au boîtier (30A).

**2.** Le dispositif de conversion de puissance (30) de la revendication 1, sachant que
le deuxième conducteur de terre (59) est apte à mettre à la terre le moteur (6) en mode de courant alternatif via l'élément capacitif (10), le dispositif de conversion de puissance (30) comprenant en outre :

un troisième conducteur de terre (61) incluant une extrémité qui est connectée au conducteur côté négatif (22) du côté du système d'alimentation en puissance en courant continu ou au premier conducteur de terre (50) par rapport au premier noyau (8) et à l'autre extrémité qui est connectée à la troisième terre (40).

**3.** Le dispositif de conversion de puissance (30) de la revendication 1 ou 2, sachant que la première terre (41) et la troisième terre (40) sont connectées l'une à l'autre via un corps de véhicule.

**4.** Le dispositif de conversion de puissance (30) selon la revendication 2, sachant que le premier noyau (8) est agencé de telle manière que, lorsque l'inverseur (4) fonctionne comme source des interférences, un chemin de courant par lequel un courant circule dans et hors de l'inverseur (4) via le refroidisseur (5), le premier conducteur de terre (50), et le conducteur côté négatif (22) traverse le premier noyau (8).

**5.** Le dispositif de conversion de puissance (30) selon la revendication 2, sachant que le premier noyau (8) est agencé de telle manière que, lorsque l'inverseur (4) fonctionne comme source des interférences, un chemin de courant par lequel un courant circule dans et hors de l'inverseur (4) via le refroidisseur (5), le troisième conducteur de terre (61), le moteur (6), l'élément capacitif (10), le deuxième conducteur de terre (59), et le conducteur côté négatif (22) traverse le premier noyau (8).

**6.** Le dispositif de conversion de puissance (30) selon la revendication 2, comprenant en outre un deuxième noyau (9) incluant un trou traversant qui permet le passage d'un conducteur de charge (23) qui connecte l'inverseur (4) et le moteur (6).

**7.** Le dispositif de conversion de puissance (30) selon la revendication 6, sachant que le premier noyau (8) et le deuxième noyau (9) sont agencés de telle manière que, lorsque l'inverseur (4) fonctionne comme source des interférences, un chemin de courant par lequel un courant circule dans et hors de l'inverseur (4) via le conducteur de charge (23), le moteur (6), l'élément capacitif (10), le deuxième conducteur de terre (59), et le conducteur côté négatif (22) traverse le premier noyau (8) et le deuxième noyau (9).

**8.** Le dispositif de conversion de puissance (30) selon la revendication 6, sachant que le premier noyau (8) et le deuxième noyau (9) sont agencés de telle manière que, lorsque l'inverseur (4) fonctionne comme source des interférences, un chemin de courant par lequel un courant circule dans et hors de l'inverseur (4) via le conducteur de charge (23), le moteur (6), le troisième conducteur de terre (61), et le conducteur côté négatif (22) traverse le premier noyau (8) et le deuxième noyau (9).

**9.** Le dispositif de conversion de puissance (30) selon l'une quelconque des revendications 6 à 8, sachant qu'une impédance du premier noyau (8) est supérieure à une impédance du deuxième noyau (9).

**10.** Le dispositif de conversion de puissance (30) selon l'une quelconque des revendications 6 à 9, sachant que, lorsqu'une fréquence de la source de bruit est augmentée au-dessus de 10 kHz, une phase de l'impédance de chacun du premier noyau (8) et du deuxième noyau (9) diminue graduellement d'une valeur égale ou inférieure à 80° à 0°.

**11.** Le dispositif de conversion de puissance (30) selon l'une quelconque des revendications 2, 4 à 8, sachant que le boîtier (30A) qui loge l'inverseur (4) est connecté à la troisième terre (40) ; et
le troisième conducteur de terre (61) est connecté au boîtier (30A) qui est connecté à la troisième terre (40).

**12.** Le dispositif de conversion de puissance (30) selon l'une quelconque des revendications 1 à 11, sachant qu'un dispositif de commutation inclus dans l'inverseur (4) est constitué d'un semiconducteur à large bande interdite.

# FIG.1

# FIG.2

(a)

EQUIVALENT CIRCUIT
OF NOISE PATH

(b)

13

# FIG.3

(a)

EQUIVALENT CIRCUIT
OF NOISE PATH

(b)

# FIG.4

(a)

EQUIVALENT CIRCUIT
OF NOISE PATH

(b)

# FIG.5

(a)

⬇ EQUIVALENT CIRCUIT OF NOISE PATH

(b)

# FIG.6

# FIG.7

**EP 2 763 304 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008301555 A
- EP 1724911 A2